# EUROPEAN PATENT SPECIFICATION

(11) **EP 0 348 860 B1**
(45) Date of publication and mention of the grant of the patent: **06.04.1994**
(21) Application number: 89111593.3
(22) Date of filing: 26.06.1989
(51) Int. Cl.: H01L 21/00, H05K 3/00

(54) **Punch press for piercing green sheet with liner**
Stanzpresse zum Lochen von grünen Plättchen mit Unterlegplättchen
Presse de poinçonnage pour perforer des plaquettes vertes à plaquettes de doublure

(30) Priority: 29.06.1988 JP 163186/88; 29.06.1988 JP 163187/88
(43) Date of publication of application: 03.01.1990
(73) Proprietor: USHIO CO. LIMITED, Togo-cho Aichi-gun Aichi-ken (JP)
(72) Inventor: Kakimoto, Masakazu c/o Ushio Co.Ltd., Togo-cho Aichi-gun Aichi-ken (JP)
(74) Representative: Denmark, James

(56) References cited:
- FR-A- 2 520 182
- GB-A- 1 432 376

## Description

This invention relates to a punch press for piercing a ceramics type green sheet, more particularly to an improved punch press machine for performing various forms and sizes of perforations in the green sheet before it is subjected to a sintering process rendering it utilizable as an IC substrate or the like.

Conventionally, it is known that a green sheet is formed as a thin sheet by the so-called Doctor blade method or Calendar method. The sheet is made from a mixture of compounds including pulverised ceramics, an organic bonding agent, a plasticizer, a solvent and the like. The raw sheet before sintering has a rich plasticity, flexibility and workability. Therefore, it is known that it can easily be cut-off, drilled, punched, bonded and the like, and it is useful, after sintering, as an IC substrate and the like.

For making a green sheet, for example, initially the raw material ceramic compound is coated uniformly on a tape (such as a polyester resin film and the like) to a predetermined thickness, and then it is dried in known manner. Subsequently, the ceramic sheet layer is peeled off from the tape for obtaining a green sheet strip whereafter it is passed to a punch press machine for providing perforations therein.

In the above conventional means of piercing the green sheet, however, a considerable disadvantage arises in that since the thickness of green sheet which has been peeled off from the tape is very thin (around 0.1mm), the handling and workability of green sheet are troublesome. Consequently it is difficult to improve the perforation productivity, and the perforation work is very difficult.

French Patent No 2520182 discloses a punch press machine wherein a single punch is adapted to punch a hole in sheet material, and the punch is capable of movement relative to the sheet material in two directions which are at right angles to each other, but the machine is not designed to punch perforations in green sheet in reeled form.

### SUMMARY OF INVENTION

The present invention, therefore, has as an object to solve the aforementioned disadvantages. It is a general object of this invention to provide a punch press enabling the piercing of the green sheet together with the tape, so that peeling off of the raw core of green sheet from the tape is not necessary. It is a further object of this invention to provide an improved apparatus by which more high grade products may be obtained.

According to the present invention there is provided a punch press for piercing a sheet material comprising a green sheet and a liner sheet, comprising
a piercing means having piercing punch means and female die means;
a supporting means supporting said sheet material to enable it to be punched by the piercing means;
drive means for moving the supporting means and piercing means relative to each other in two mutually orthagonal directions referred to as the x-direction and the y-direction, characterised in that said piercing means comprises a plurality of units each comprising a punch and female die arranged aligned in the said x-direction and in that the supporting means comprises a coiling means for supporting the sheet material in web form whilst stretched between two shafts in the y-direction and by one of which shafts the sheet material can be wound up.

Preferably, the piercing means in the punch press is positionally fixed and said drive means is adapted to move the supporting means in said x and y directions.

Preferably also, the punch press is characterised in that the supporting means is positionally fixed and the drive means is adapted to move the piercing means in said x and y directions.

Summarizing them from the above two examples, firstly it is another object of the present invention to provide a punch press in combination with a stationary punch press frame section and a movable feeding mechanism as explained in the first example.

Secondly it is an additional object of the present invention to provide a punch press in combination with a movable punch press frame section and a stationary feeding mechanism.

Embodiments of the invention will now be described, by way of example and with reference to the accompanying drawings, wherein:-
Fig. 1 is a plan view of a punch press according to one embodiment of the invention;
Fig. 2 is a partial front elevation of Fig. 1;
Fig. 3 is a side view of Fig. 1;
Fig. 4 is a partially enlarged perspective illustration of Fig. 1;
Fig. 5 is a plan view of a punch press according to another embodiment of the invention;
Fig. 6 is a partial front elevation of Fig. 5;
Fig. 7 is a side view of Fig. 5; and
Fig. 8 is a partially enlarged perspective illustration of Fig. 5.

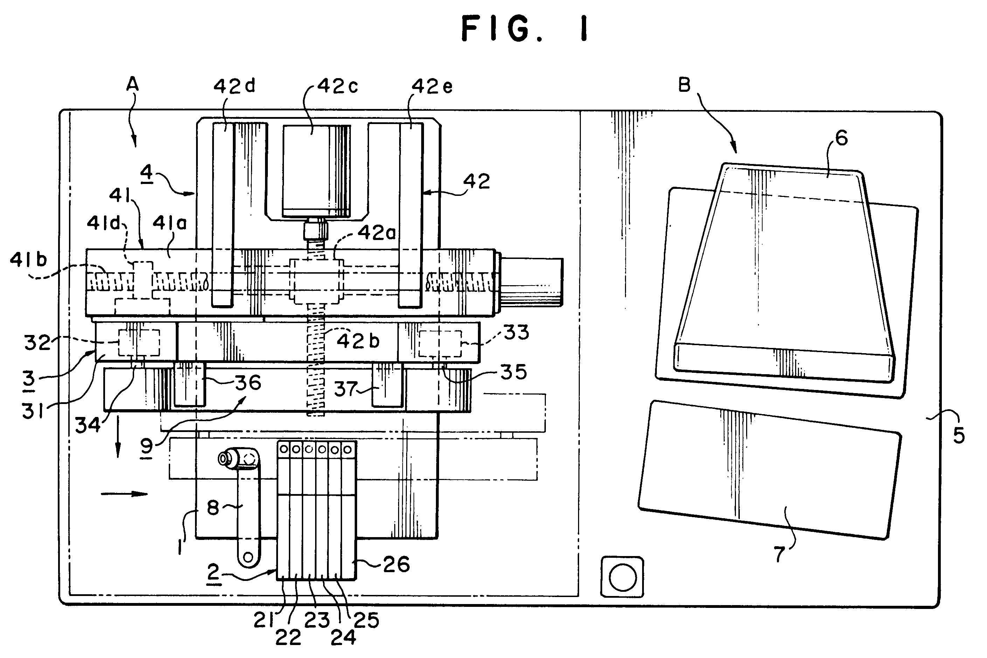

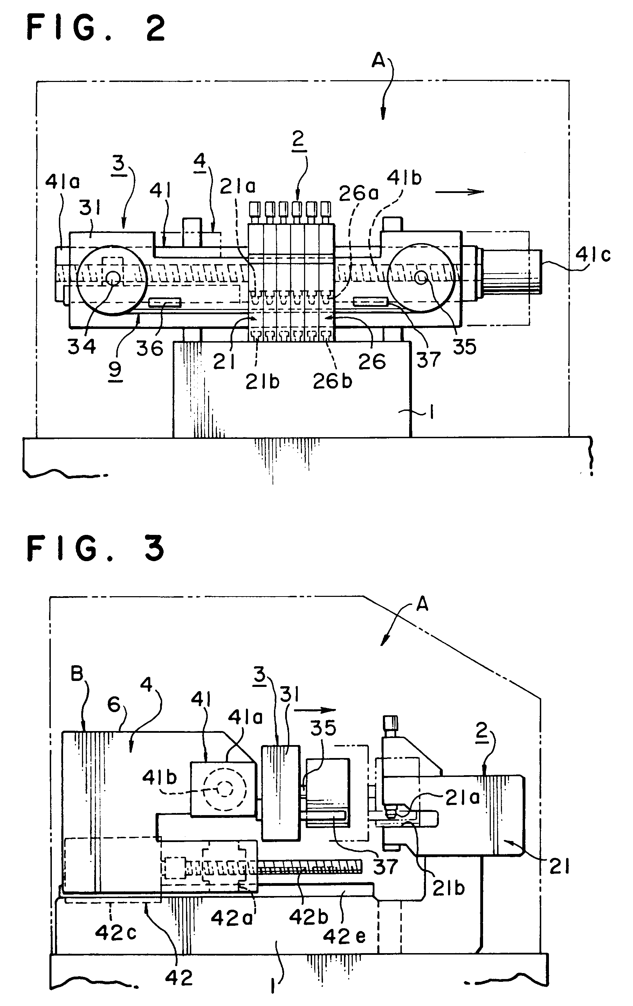

Reference is now made in detail to a practical example of a punch press as shown in Figs 1 to 4 which is characterised by a stationary punch press frame section and a movable feeding mechanism.

Fig. 1 shows a punch press, which comprises a working section (A) and a control section (B) which controls the press.

The working section (A) is arranged on a bed (1), and consisting of the punch press frame section (2), the feeding mechanism (3) and the mobil mechanism (4). The punch press frame section (2) is provided to perform piercing work of the sheet material (9). Section (2) comprises six units or piercing assemblies (21), (22), (23), (24), (25) and (26) each of which consists of a piercing punch (21a), (22a), (23a), (24a), (25a) and (26a) and a female die (21b), (22b), (23b), (24b), (25b) and (26b). The punch press frame section is arranged on the bed (1) so that the piercing assemblies are arranged so as to align in a direction referred to herein as the x-axis direction. It is possible to load any number of a plurality of piercing assemblies into the punch press frame section. The punch press frame section has an adequate percussion mechanism to impact the piercing punches toward the female to pierce a sheet material work piece (9) therebetween.

The work piece feeding section (3) is provided to hold the sheet material in the form of a web, so that it can be fed through the punch press frame section (2). The feeding section consists of a housing (31) and a feeding motor (32) and a coiling motor (33) disposed within the housing (31) for feeding and coiling the work piece from a feeder shaft (34) of the feeding motor (32) to a capstan shaft (35) of the coiling motor (33). Shafts (34) and (35) are connected directly with those motors (32)(33) and both project from the outer surface of housing (31). Also included are a pair of vacuum grippers (36)(37) which are disposed with the housing (31) and between the above two shafts (34)(35). The work piece feeding section (3) is held by drive mechanism (4).

As to the above motors (32)(33), these are controlled so as to be synchronized with each other so that they will be rotated in response to increase or decrease of the diameter of the sheet material on their shafts as dictated by the progress of piercing work. As an alternative the motors may be controlled so that only the capstan shaft (35) is driven by the coiling motor (33), and the other feeder shaft (34) is an idler shaft provided with means providing an adequate frictional resistance.

The drive mechanism is provided to move the sheet material work piece (9) in the x-direction and/or a direction at right angles thereto referred to as the y-direction by means of the work piece feeding section (3). The drive mechanism (4) consists of an x-direction drive mechanism (41) and a y-direction drive mechanism (42). The x-direction drive mechanism (41) is provided to move the work piece feeding section (3) in the x-direction, and consists of the housing (41a) which lies in the x-direction, a jack-screw shaft (41b) disposed in the housing (41a), an x-direction motor (41c) connected with the jack-screw shaft (41b) to rotate the shaft (41b) for traversing the punch press frame section (2) in the x-direction, and a screw cursor (41d) to engage with the jack-screw shaft (41b) for supporting the housing (31) of the work piece feeding section (3). The x-direction drive mechanism (41) is arranged movably on a y-direction drive mechanism (42). The y-direction drive mechanism (42) is provided to move the x-direction drive mechanism (41) in the y-direction. The drive mechanism (42) consists of a jack-screw shaft (42b) engaging with a screw cursor (42a) supporting the other housing (41a) of the x-direction motor (42c) connected to the jack-screw shaft (42b) for rotating the shaft (42b). The y-axis motor (42c) is fixed with the bed (1), and there are two lengths of guide rail (42d)(42e) which, being fixed to the bed (1), guide the housing (41a) of the x-direction drive mechanism (41) in engaging with the other housing (41a).

A control section (B) consists of: a console body (5) housing a microcomputer; a display panel (6) connected to and on the console body (5); and an offset type microscope (8) which is disposed adjacent the punch press frame section (2) for automatically controlling the piercing work of the punch press frame section (2).

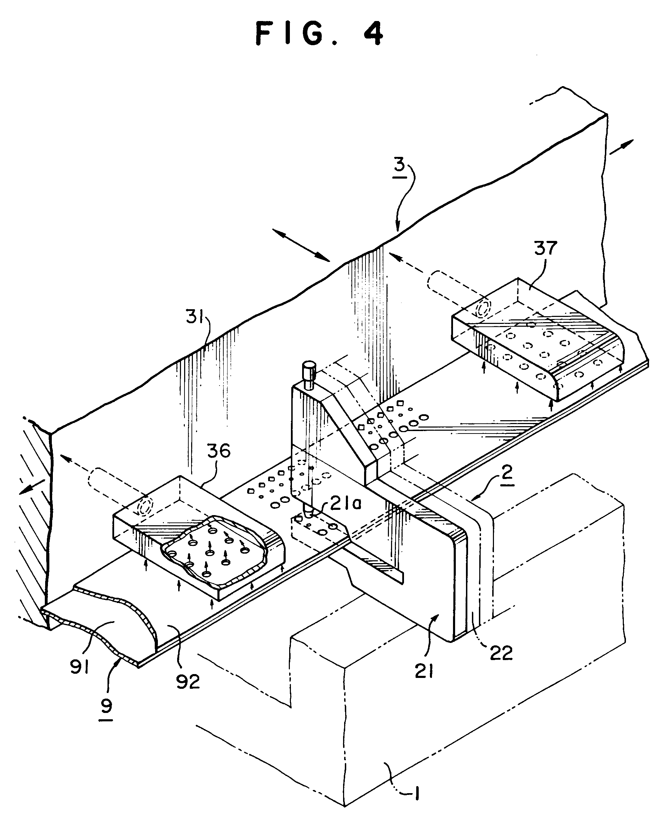

In Fig. 4 is shown the sheet material (9) consisting of the aforementioned ceramic compound layer (92) coated on a tape (91). Compound (92) is of a predetermined uniform thickness and then is dried. The sheet (9) is then reeled on the feeder's web shaft (34) and is streched onto the coiling shaft (35). The sheet (9) is held by the vacuum grippers (36)(37) so as to be tensioned between both grippers (36)(37), so that it can keep its shape as a flat sheet.

The thickness of green sheet (9) is made up of 0.1mm (millimeter) of the ceramic layer (92) and 0.3mm of the polyester resin film tape, and therefore, its total thickness is at 0.4mm.

In the operation of piercing the sheet (9), firstly appropriate data is input into the console (5) to set up the desired piercing position of two piercing assemblies (21), (22), (23), (24), (25) and (26) which are to be operated. Secondly, the green sheet which is held by the vacuum grippers (36)(37) is transferred into the punch press frame section (2) by the drive mechanism (4) and held therein. Thirdly, the piercing work is performed under the detection and control of the offset type microscope (8) fixed adjacent the punch press frame section (2).

According to the input data into the console (5), it is possible to feed a unprocessed blank sheet without any piercing work being performed by drive of the feeding motor (32) and the coiling motor (33) as an option. In addition, as a further optional example, it is possible to use an actuator such as an air cylinder or the like to control the drive mechanism (4). As to the control section (B), this is not always necessary. Instead, it is possible to control the apparatus manually without the control section (B). Alternatively, the system may be capable, by switching of either a manual operation or an automatic operation.

As an additional modification to the drive mechanism (4), which has the x-direction mechanism (41) and y-direction mechanism (42) it is suggested to add one more drive mechanism, such additional drive section being of a z-direction drive mechanism which is capable of elevating vertically a section, e.g. either the punch press frame section or the work piece feeding section; it is proposed that these drives for the x, y and z-directions may be selectively or simultaneously operated. Also it is noted that the z-direction drive mechanism is particularly effective for keeping the work piece into a level position in the guide slit of the piercing assemblies during the piercing operation. The feature of z-direction mechanism is not shown specifically in the drawings.

In the above practical example in Fig. 1 to Fig. 4, is set forth a punch press for green sheet comprising a stationary punch press frame section (2) and a movable feeding section (3).

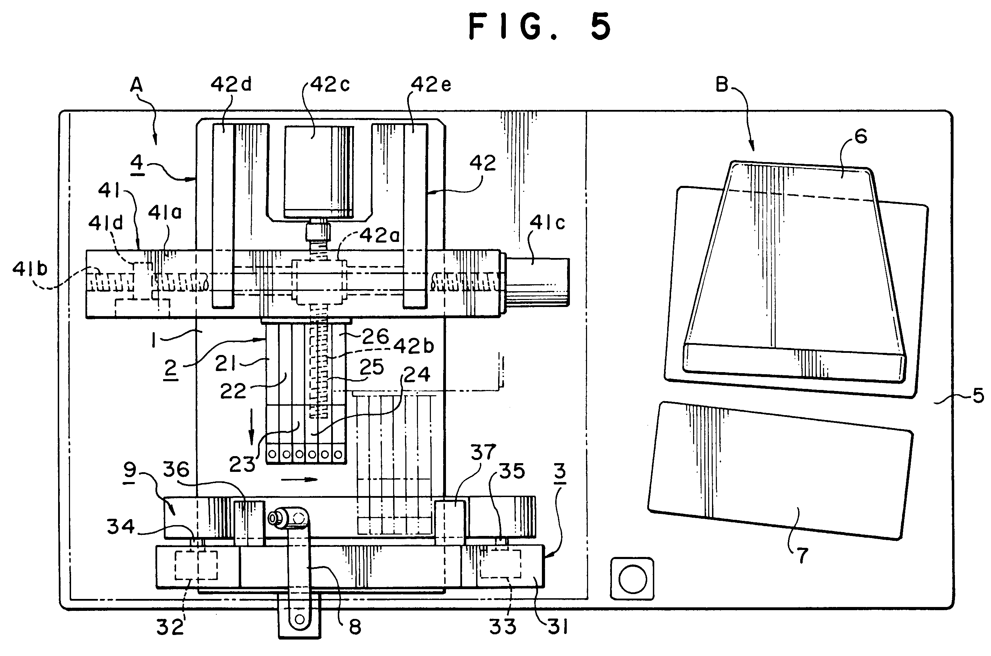

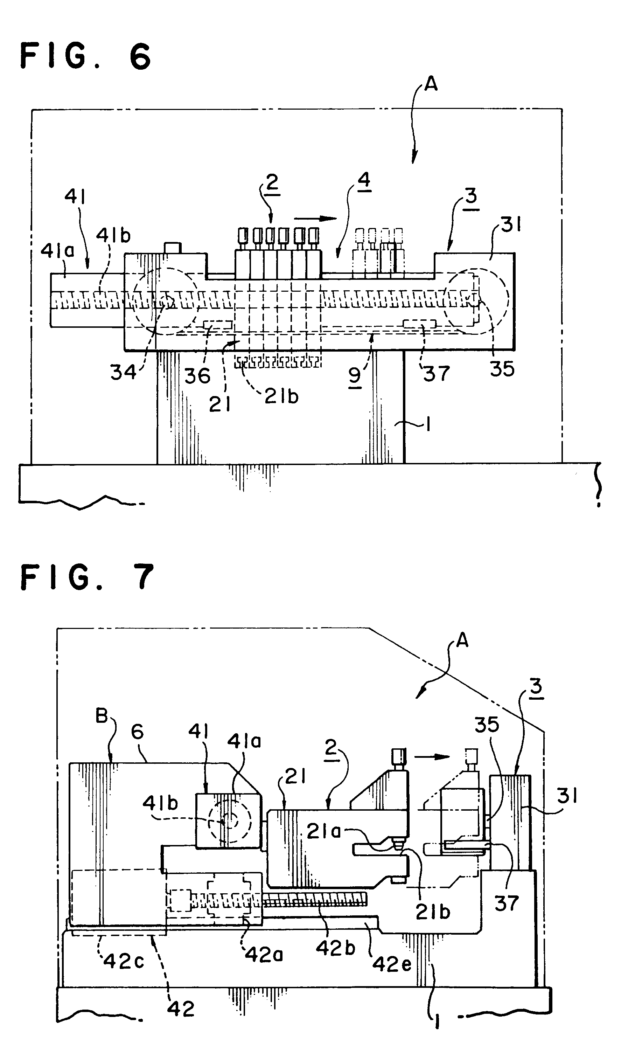

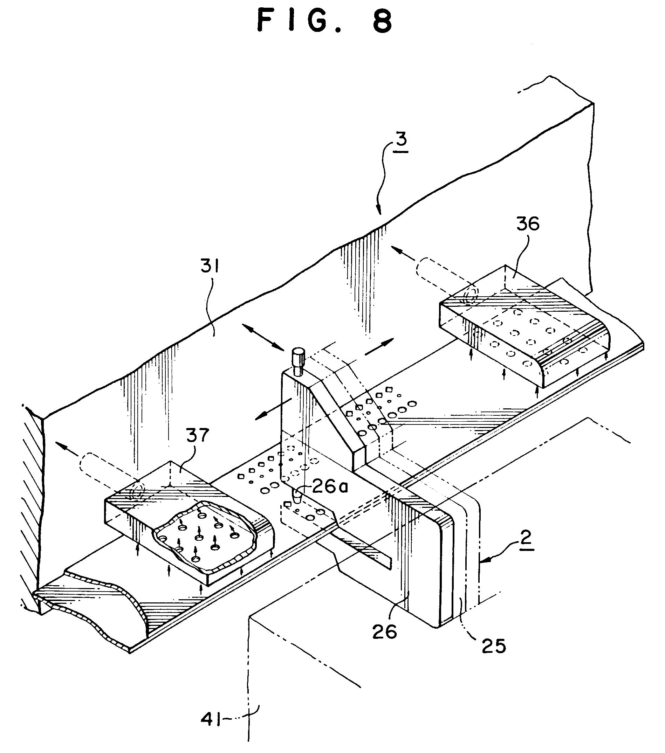

In the other practical example, shown in Fig. 5 to Fig. 8, there is a movable punch press frame section (2) and a stationary feeding section (3).

Referring to Fig. 5 to Fig. 8, the press is of similar construction to its structural difference between both types, that of the first practical example, except that the drive mechanism (4) is connected to move the punch press frame section (2). In other words, the drive mechanism (4) has been arranged to move the punch press frame section (2) instead of the work piece feeding section (3).

For reason of convenience, the reference numerals used in Fig. 5 to Fig. 8 are the same as those used in Fig. 1 to 4 to designate the same or corresponding parts.

In Fig. 5, the punch press frame section (3) is arranged fixedly on the bed (1). The drive mechanism (4) is a device to move the punch press frame section (2) in the x-direction and/or y-direction, and consists of the x-direction and/or y-direction, and consists of the x-direction drive mechanism (41) and y-direction drive mechanism (42). The x-direction drive mechanism (41) is a device to move the punch press frame mechanism (2) in x-direction, and consists of the housing (41a) arranged to extend in the x-direction. It is fixed to the punch press frame section (2), and has jack-screw shaft (41b) fixed in the housing (41a). The x-axis motor (41c) is connected with the jack-screw, shaft (41b) to rotate the shaft (41b), and the screw cursor (41d) is engaged with the jack-screw shaft (41b) and is fixed to the housing (41a).

In this way, the punch press frame section (2) is moved by the drive mechanism (4) relative to the green sheet (9), so that the green sheet (9) is held effectively in the punch press frame section (2). Data concerning the piercing position obtained by using the offset type microscope (8), and data concerning the selective movement of piercing assemblies such as (21), (22), (23), (24), (25) and (26) are input into the console (5) of control section (B). According to this input data, the piercing work is performed.

As to this second practical example, wherein the punch press frame section (2) is movable and the feeding section is stationary, there is the advantage that, as described before, the piercing work is performed in various piercing forms upon the green sheet, the various perforations can be performed accurately in that it has been found that there is a trend for delicate errors to occur upon the products when comparatively complex perforation work is performed. Investigation reveals that this might be caused by an inertia effect generated by the quick action of normal feeding section (3). In view of this result, it is advantageous to use the second practical example when a complex perforation is to be performed.

According to the above described two practical examples, a green sheet is fed into a punch press frame section with an attached tape and the improved type punching press is capable of facilitating the piercing work of green sheet, and thereby it is possible to obtain high grade products and improved productivity.

## Claims

1. A punch press for piercing a sheet material (9) comprising a green sheet (92) and a liner sheet (91), comprising
a piercing means (2) having piercing punch means (21a) and female die means (21b);
a supporting means (3) supporting said sheet material (9) to enable it to be punched by the piercing means (2);
drive means (41) (42) for moving the supporting means (3) and piercing means (2) relative to each other in two mutually orthagonal directions referred to as the x-direction and the y-direction, characterised in that said piercing means (2) comprises a plurality of units (21-26) each comprising a punch (21a) and female die (21b) arranged aligned in the said x-direction and in that the supporting means (3) comprises a coiling means (31) for supporting the sheet material (9) in web form whilst stretched between two shafts (34, 35) in the x-direction and by one of which shafts (34, 35) the sheet material (9) can be wound up.

2. A punch press according to claim 1, characterised in that the piercing means (2) is positionally fixed and said drive means (41, 42) is adapted to move the supporting means (3) in said x and y directions.

3. A punch press according to claim 1, characterised in that the supporting means (3) is positionally fixed and the drive means (41, 42) is adapted to move the piercing means (2) in said x and y directions.

4. A punch press as claimed in claim 1, 2 or 3, characterised in that said supporting means (3) is adapted to feed said sheet material intermittently relative to said piercing means (2).

5. A punch press as claimed in any preceding claim, characterised in that the said supporting means (3) comprises a pair of vacuum grippers (36, 37) to hold the sheet material where it is stretched between said shafts (34, 35).

6. A punch press as claimed in any preceding claim, characterised in that said drive means (41, 42) is driven automatically by an electric instruction from a computer (6) assisted by a detection of an offset type microscope (8) disposed adjacent said piercing means (2).

7. A punch press as claimed in any preceding claim characterised in that each of said piercing units (21-26) has a guiding slit between a piercing punch portion (21a) and its die portion (21b) for facilitating insertion of said sheet material (9).

8. A punch press as claimed in any preceding claim characterised in that the coiling of the sheet material between said shafts (34, 35) is under the control of motor means (32, 33) driven in response to increase or decrease the sheet material diameter to keep a constant stretching tension on the material.

9. A punch press as claimed in claim 8, characterised in that said motors (32, 33) are reversible motors to enable forward or reverse feeding of said sheet material in said x-direction.

10. A punch press as claimed in claim 8, characterised in that said motor means 32, 33 comprises a coiling motor connected to one of said shafts (32, 33) and the other shaft is an idler shaft with an adequate frictional resistance.

11. A method of punching a green sheet, characterised in that the green sheet (92) is backed with a liner (91) and both are punched together.

12. A method according to claim 11, characterised in that the liner is a polyester tape (91).

13. A method according to claims 11 or 12, characterised in that the green sheet (92) and liner (91) are punched repeatedly in that the combined green sheet (92) and liner (91) are in web form (9) and are moved intermittently and relative to a punch (2) which is operated repeatedly.

## Patentansprüche

1. Stanzmaschine zum Lochstanzen eines Folienmaterials (9) bestehend aus einer Grünfolie (92) und einer Trägerfolie (91), welche enthält:
eine Lochstanzeinrichtung (2) mit Stanzwerkzeug (21a) und Matrize (21b);
eine Abstützvorrichtung (3), die das Folienmaterial (9) unterstützt, damit es durch die Lochstanzeinrichtung (2) gelocht werden kann;
einen Antrieb (41) (42) zum Bewegen der Abstützvorrichtung (3) und der Lochstanzeinrichtung (2) relativ zueinander in zwei gegenseitig rechtwinklig zueinander stehenden Richtungen, nämlich einer X-Richtung und einer Y-Richtung,
dadurch gekennzeichnet, daß
die Lochstanzeinrichtung (2) eine Vielzahl von Einheiten (21-26) enthält, die jeweils ein Stanzwerkzeug (21a) und eine Matrize (21b) enthalten, welche in der X-Richtung fluchten, und daß
die Abstützvorrichtung (3) eine Aufwickelvorrichtung (31) enthält, zur Lagerung des Folienmaterials (9) in Form einer endlosen Bahn während es zwischen zwei Wellen (34, 35) in der X-Richtung gestreckt wird, wobei das Folienmaterial (9) von einer der Wellen (34, 35) aufgewickelt werden kann.

2. Stanzmaschine nach Anspruch 1, dadurch gekennzeichnet, daß die Lochstanzeinrichtung (2) in ihrer Lage festgehalten ist und der Antrieb (41, 42) der Abstützvorrichtung (3) in der X- und Y-Richtung bewegbar ist.

3. Stanzmaschine nach Anspruch 1, dadurch gekennzeichnet, daß die Abstützvorrichtung (3) in ihrer Lage festgehalten ist und der Antrieb (41, 42) der Lochstanzeinrichtung (2) in der X- und Y-Richtung bewegbar ist.

4. Stanzmaschine nach Anspruch 1, 2 oder 3, dadurch gekennzeichnet, daß das Folienmaterial (9) mittels der Abstützvorrichtung (3) relativ zu der Lochstanzeinrichtung (2) intermittierend zuführbar ist.

5. Stanzmaschine nach einem der vorangegangenen Ansprüche, dadurch gekennzeichnet, daß die Abstützvorrichtung (3) ein Paar von Vakuum-Greifern (36, 37), zum Halten des Folienmaterials (9) im Bereich seiner Streckung zwischen den Wellen (34, 35) aufweist.

6. Stanzmaschine nach einem der vorangegangenen Ansprüche, dadurch gekennzeichnet, daß der Antrieb (41, 42) durch einen elektrischen Befehl von einem Rechner (6) automatisch angesteuert ist, welcher unterstützt wird durch eine Erkennung durch ein Offset-Mikroskop (8), welches in der Nachbarschaft zu der Lochstanzeinrichtung (2) angeordnet ist.

7. Stanzmaschine nach einem der vorangegangenen Ansprüche, dadurch gekennzeichnet, daß jede der Lochstanzeinheiten (21-26) einen Führungsschlitz zwischen einem Lochstanzabschnitt (21a) und seinem Matrizenabschnitt (21b) aufweist, um das Einführen des Folienmaterials (9) zu erleichtern.

8. Stanzmaschine nach einem der vorangegangenen Ansprüche, dadurch gekennzeichnet, daß das Aufwickeln des Folienmaterials (9) zwischen den Wellen (34, 35) motorisch (32, 33) kontrolliert wird, die in Abhängigkeit von einer Zunahme oder Abnahme des Durchmessers des Folienmaterials (9) angetrieben sind, um eine konstante Zugspannung am Material aufrechtzuerhalten.

9. Stanzmaschine nach Anspruch 8, dadurch gekennzeichnet, daß die Motoren (32, 33) Reversiermotoren sind, um die Zufuhr des Folienmaterials (9) vorwärts und rückwärts in der X-Richtung zu ermöglichen.

10. Stanzmaschine nach Anspruch 8, dadurch gekennzeichnet, daß der Motorantrieb (32, 33) einen Aufwickelmotor aufweist, der an eine der Wellen (32, 33) angeschlossen ist, wobei die andere Welle eine leerlaufende Welle mit einem adäquaten Reibungswiderstand ist.

11. Verfahren zum Lochstanzen einer Grünfolie, dadurch gekennzeichnet, daß die Grünfolie (92) mit einer Trägerfolie (91) hinterfüttert ist und beide miteinander gelocht werden.

12. Verfahren nach Anspruch 11, dadurch gekennzeichnet, daß die Trägerfolie ein Polyesterband (91) ist.

13. Verfahren nach Anspruch 11 oder 12, dadurch gekennzeichnet, daß die Grünfolie (92) und die Trägerfolie (91) wiederholt gelocht werden, wobei die kombinierte Grünfolie (92) und die Trägerfolie (91) in Form einer endlosen Bahn (9) sind und intermittierend sowie relativ zu einem Locher (2), der wiederholt betrieben wird, bewegt werden.

## Revendications

1. Presse de poinçonnage pour perforer un matériau en feuille (9) comprenant une plaquette verte (92) et une plaquette de doublure (91) comprenant
un moyen de perforation (2) comportant un moyen de poinçonnage de perforation (21a) et un moyen matrice femelle (21b);
un moyen support (3) supportant ledit matériau en feuille (9) pour lui permettre d'être poinçonné par le moyen de perforation (2);
des moyens d'entraînement (41) (42) pour déplacer le moyen support (3) et le moyen de perforation (2) l'un par rapport à l'autre dans deux directions perpendiculaires entre elles, que l'on appelle direction x et direction y, caractérisés en ce que ledit moyen de perforation (2) comprend une pluralité d'unités (21 à 26) dont chacune comprend un poinçon (21a) et une matrice femelle (21b), alignés dans ladite direction x et en ce que le moyen support (3) comprend un moyen de bobinage (31) pour supporter le matériau en feuille (9) sous une forme de feuille alors qu'il est tendu entre deux arbres (34, 35) dans la direction x et avec lesquels, par l'un des arbres (34, 35), peut être enroulé le matériau en feuille (9).

2. Presse de poinçonnage suivant la revendication 1, caractérisée en ce que le moyen de perforation (2) est fixe en position et ledit moyen d'entraînement (41, 42) est adapté pour déplacer le moyen support (3) dans lesdites directions x et y.

3. Presse de poinçonnage suivant la revendication 1, caractérisée en ce que le moyen support (3) est fixe en position et le moyen d'entraînement (41, 42) est adapté pour déplacer le moyen de perforation (2) dans lesdites directions x et y.

4. Presse de poinçonnage telle que revendiquée dans la revendication 1, 2 ou 3, caractérisée en ce que ledit moyen support (3) est adapté pour alimenter par intermittence ledit matériau en feuille par rapport audit moyen de perforation (2).

5. Presse de poinçonnage telle que revendiquée dans une revendication précédente quelconque, caractérisée en ce que ledit moyen support (3) comprend une paire d'organes de succion sous vide (36, 37) pour saisir le matériau de feuille là où il est tendu entre lesdits arbres (34, 35).

6. Presse de poinçonnage telle que revendiquée dans une revendication précédente quelconque, caractérisée en ce que ledit moyen d'entraînement (41, 42) est entraîné automatiquement par une instruction électrique provenant d'un calculateur (6) aidé par une détection d'un microscope (8) du type offset adjacent audit moyen de perforation (2).

7. Presse de poinçonnage telle que revendiquée dans une revendication précédente quelconque, caractérisée en ce que chacune desdites unités de perforation (21 à 26) comporte une fente de guidage entre une partie poinçon de perforation (21a) et sa partie matrice (21b) pour faciliter l'insertion dudit matériau en feuille (9).

8. Presse de poinçonnage telle que revendiquée dans une revendication précédente quelconque, caractérisée en ce que le bobinage du matériau en feuille entre lesdits arbres (34, 35) se fait sous la commande de moyens moteurs (32, 33) entraînés en fonction de l'augmentation ou de la réduction du diamètre de matériau en feuille afin de conserver une tension de mise en tension sur le matériau.

9. Presse de poinçonnage suivant la revendication 8, caractérisée en ce que lesdits moteurs (32, 33) sont des moteurs réversibles pour permettre l'alimentation en avant ou en arrière dudit matériau en feuille dans ladite direction x.

10. Presse de poinçonnage suivant la revendication 8, caractérisée en ce que lesdits moyens moteurs (32, 33) comprennent un moteur de bobinage relié à l'un desdits arbres (34, 35) tandis que l'autre arbre est un arbre libre avec une résistance de friction appropriée.

11. Méthode de poinçonnage d'une feuille verte, caractérisée en ce que la feuille verte (92) est recouverte d'une doublure (91) en en ce que les deux sont poinçonnées ensemble.

12. Méthode suivant la revendication 11, caractérisée en ce que la doublure est une bande de polyester (91).

13. Méthode suivant la revendication 11 ou 12, caractérisée en ce que la feuille verte (92) et la doublure (91) sont poinçonnées de manière répétitive, la feuille verte (92) et la doublure (91) combinées étant sous forme de nappe (9) et étant déplacées par intermittence et par rapport à un poincon (2) qui est actionné de manière répétitive.
